(19) Europäisches Patentamt
European Patent Office
Office européen des brevets

(11) Veröffentlichungsnummer : **0 495 751 A1**

(12) # EUROPÄISCHE PATENTANMELDUNG

(21) Anmeldenummer : **92810005.6**

(51) Int. Cl.[5] : **C08F 2/50,** G03F 7/029

(22) Anmeldetag : **07.01.92**

(30) Priorität : **14.01.91 CH 83/91**

(43) Veröffentlichungstag der Anmeldung :
**22.07.92 Patentblatt 92/30**

(84) Benannte Vertragsstaaten :
**BE DE FR GB IT NL**

(71) Anmelder : **CIBA-GEIGY AG**
**Klybeckstrasse 141**
**CH-4002 Basel (CH)**

(72) Erfinder : **Rutsch, Werner, Dr.**
**Av. Weck-Reynold 1**
**CH-1700 Fribourg (CH)**
Erfinder : **Hug, Gebhard**
**rue de Schiffenen 3**
**CH-1700 Fribourg (CH)**
Erfinder : **Köhler, Manfred, Dr.**
**Kehlerstrasse 15**
**W-7800 Freiburg (DE)**

(54) **Bisacylphosphine.**

(57) Bisacylphosphine der Formel I

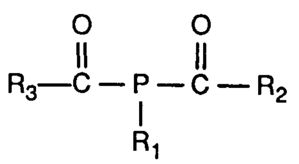 (I),

worin $R_1$ unsubstituiertes $C_1$-$C_{18}$-Alkyl oder durch Phenyl, -CN, $C_1$-$C_{12}$-Alkoxy oder Halogen subsrituiertes $C_1$-$C_8$-Alkyl, $C_2$-$C_{18}$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest bedeutet und
$R_2$ und $R_3$ unabhängig voneinander für unsubstituiertes $C_1$-$C_{18}$-Alkyl oder durch Phenyl, Halogen oder $C_1$-$C_{12}$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl, unsubstituiertes oder durch $C_1$-$C_{12}$-Alkyl, $C_1$-$C_{12}$-Alkoxy, $C_2$-$C_{12}$-Alkoxyalkyl, $C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S-oder/und N-haltigen aromarischen heterocyclischen Rest stehen, können als Initiatoren für die Photopolymerisation von Verbindungen mit ethylenisch ungesättigten Doppelbindungen verwendet werden.

EP 0 495 751 A1

Die vorliegende Erfindung betrifft photohärtbare Zusammensetzungen, die Bisacylphosphine enthalten, die Verwendung dieser Verbindungen als Initiatoren für die Photopolymerisation von ethylenisch ungesättigten Verbindungen, sowie ein Verfahren zur Photopolymerisation solcher Verbindungen mit Bisacylphosphinen als Photoinitiatoren.

In der US-A-3,668,093 werden arylsubstituierte Mono-, Di- und Trisacylphosphine als Photoinitiatoren vorgeschlagen.
Aus der EP-A-184 095 sind Bisacylphosphine als Edukte für die Herstellung von Bisacylphosphinoxid-Photoinitiatoren bekannt.

Es wurde nun gefunden, dass auch Bisacylphosphine hervorragende Eigenschaften als Photoinitiatoren bei der Polymerisation von Verbindungen mit ethylenisch ungesättigten Doppelbindungen haben.

Gegenstand der Erfindung sind daher photopolymerisierbare Zusammensetzungen enthaltend

(a) mindestens eine ethylenisch ungesättigte photopolymerisierbare Verbindung und

(b) als Photoinitiator mindestens eine Verbindung der Formel I

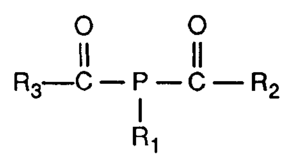 (I),

worin $R_1$ unsubstituiertes $C_1$-$C_{18}$-Alkyl oder durch Phenyl, -CN, $C_1$-$C_{12}$-Alkoxy oder Halogen substituiertes $C_1$-$C_8$-Alkyl, $C_2$-$C_{18}$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest bedeutet und
$R_2$ und $R_3$ unabhängig voneinander für unsubstituiertes $C_1$-$C_{18}$-Alkyl oder durch Phenyl, Halogen oder $C_1$-$C_{12}$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl, unsubstituiertes oder durch $C_1$-$C_{12}$-Alkyl, $C_1$-$C_{12}$-Alkoxy, $C_2$-$C_{12}$-Alkoxyalkyl, $C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S-oder/und N-haltigen aromatischen heterocyclischen Rest stehen.

$R_1$, $R_2$ und $R_3$ als $C_1$-$C_{18}$-Alkyl können verzweigtes und unverzweigtes Alkyl sein wie z.B. Methyl, Ethyl, Propyl, Isopropyl, n-Butyl, sec-Butyl, iso-Butyl, tert-Butyl, Pentyl, Hexyl, tert-Hexyl, Heptyl, 2,4,4-Trimethylpentyl, Octyl, Nonyl, Decyl, Dodecyl, Tetradecyl, Heptadecyl oder Octadecyl. Insbesondere können $R_1$, $R_2$ und $R_3$ für $C_1$-$C_{12}$-Alkyl stehen.

$R_1$, $R_2$ und $R_3$ als ein- oder mehrfach, z.B. ein bis 3-fach, insbesondere ein- oder zweifach, substituiertes $C_1$-$C_8$-Alkyl können z.B. Benzyl, 1-Phenylethyl, 2-Phenylethyl, $\alpha$,$\alpha$-Dimethylbenzyl, 2-Methoxyethyl, 2-Ethoxyethyl, Diethoxymethyl, 2-Butoxyethyl, 2-Isopropoxyethyl, 2-Butoxypropyl, 2-Octyloxyethyl, Chlormethyl, 2-Chlorethyl oder Trichlormethyl, bevorzugt substituiertes $C_1$-$C_4$-Alkyl, besonders Benzyl, sein. $R_1$ kann auch beispielsweise Cyanomethyl, Cyanoethyl usw. bedeuten.

$R_1$ als $C_2$-$C_{18}$-Alkenyl kann z.B. Allyl, Methallyl, 1,1-Dimethylallyl, Butenyl, 2-Hexenyl, Octenyl, Undecenyl, Dodecenyl oder Octadecenyl, bevorzugt $C_2$-$C_{12}$-Alkenyl, besonders $C_2$-$C_6$-Alkenyl, sein.
$R_2$ und $R_3$ als $C_2$-$C_6$-Alkenyl können z.B. Vinyl, Propenyl, Butenyl oder Hexenyl sein.

$R_1$, $R_2$ und $R_3$ als $C_5$-$C_8$-Cycloalkyl können z.B. Cyclopentyl, Cyclohexyl oder Cyclooctyl, bevorzugt Cyclopentyl und Cyclohexyl, besonders Cyclohexyl, bedeuten. Als substituiertes, z.B. 1-bis 4-fach substituiertes, $C_5$-$C_8$-Cycloalkyl können $R_1$, $R_2$ und $R_3$ z.B. für Methylcyclopentyl, Dimethylcyclopentyl, Methylcyclohexyl, Dimethylcyclohexyl, Diethylcyclohexyl, Methoxycyclopentyl, Dimethoxycyclopentyl, Ethoxycyclopentyl, Diethoxycyclopentyl, Methoxycyclohexyl, Dimethoxycyclohexyl, Ethoxycyclohexyl, Diethoxycyclohexyl, Chlorcyclohexyl, Chlorcyclopentyl, Dichlorcyclohexyl oder Dichlorcyclopentyl stehen. Ist Cycloalkyl substituiert, dann vorzugsweise mit $C_1$-$C_4$-Alkyl.

$R_2$ und $R_3$ als $C_6$-$C_{12}$-Aryl können z.B. Phenyl, $\alpha$-Naphthyl, $\beta$-Naphthyl oder 4-Diphenylyl, bevorzugt Phenyl, darstellen. $R_2$ und $R_3$ als substituiertes $C_6$-$C_{12}$-Aryl enthält vorzugsweise 1 bis 3 Substituenten und ist z.B. Chlorphenyl, Dichlorphenyl, Trichlorphenyl, Difluorphenyl, Tolyl, Mesityl, Ethylphenyl, tert-Butylphenyl, Dodecylphenyl, Methoxyphenyl, Dimethoxyphenyl, Ethoxyphenyl, Hexyloxyphenyl, Methylnaphthyl, Isopropylnaphthyl, Chlomaphthyl, Ethoxynaphthyl, Methoxyethylphenyl, Ethoxymethylphenyl, Methylthiophenyl, Isopropylthiophenyl oder tert-Butylthiophenyl, insbesondere Dimethoxyphenyl, Chlorphenyl und Mesityl, bevorzugt Dimethoxyphenyl. Alkyl und Alkoxy als Arylsubstituenten haben vorzugsweise 1 - 4 C-Atome und sind insbesondere Methyl oder Methoxy.

$R_1$, $R_2$ und $R_3$ als heterocyclischer Rest können ein- oder mehrkernig, insbesondere ein oder zweikernig

sein, beispielsweise mit annelliertem Benzolring, und bedeuten z.B. Furyl, Thienyl, Pyrrolyl, Pydyl, Indolyl, Benzoxazolyl, Benzimidazolyl oder Benzthiazolyl sein. Bevorzugt enthält ein solcher heterocyclischer Rest 4- 12 C-Atome. Die genannten heterocyclischen Reste können ein- oder mehrfach, z.B. ein- oder zweifach, substituiert sein. Beispiele dafür sind Dimethylpyridyl, Methylchinolyl, Dimethylpyrrolyl, Methoxyfuryl, Dimethoxypyridyl oder Difluorpyridyl.

Halogen bedeutet insbesondere Chlor, Brom oder Fluor, vorzugsweise Chlor.

In bevorzugten Zusammensetzungen bedeuten $R_1$ unsubstituiertes $C_1$-$C_{12}$-Alkyl oder durch Phenyl, -CN, $C_1$-$C_4$-Alkoxy oder Halogen substituiertes $C_1$-$C_8$-Alkyl, $C_2$-$C_{12}$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest und $R_2$ und $R_3$ unabhängig voneinander unsubstituiertes $C_1$-$C_{12}$-Alkyl oder durch Phenyl, Halogen oder $C_1$-$C_4$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl, unsubstituiertes oder durch $C_1$-$C_{12}$-Alkyl, $C_1$-$C_4$-Alkoxy, $C_2$-$C_8$-Alkoxyalkyl, $C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S- oder/und N-haltigen aromatischen heterocyclischen Rest.

Von Interesse sind auch Zusammensetzungen, worin $R_1$ unsubstituiertes $C_1$-$C_{12}$-Alkyl oder durch Phenyl, -CN, $C_1$-$C_4$-Alkoxy oder Halogen substituiertes $C_1$-$C_4$-Alkyl, $C_2$-$C_6$-Alkenyl oder unsubstituiertes oder durch $C_1$-$C_{12}$-Alkyl, $C_1$-$C_4$-Alkoxy oder Halogen substituiertes $C_5$-$C_8$-Cycloalkyl bedeutet und $R_2$ und $R_3$ unabhängig voneinander für unsubstituiertes $C_1$-$C_{12}$-Alkyl oder durch Phenyl, Halogen oder $C_1$-$C_4$-Alkoxy substituiertes $C_1$-$C_4$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder unsubstituiertes oder durch $C_1$-$C_{12}$-Alkyl, $C_1$-$C_4$-Alkoxy, $C_2$-$C_8$-Alkoxyalkyl, $C_1$-$C_4$-Alkylthio oder Halogen substituiertes $C_6$-$C_{12}$-Aryl stehen.

Besonders bevorzugte Zusammensetzungen enthalten Verbindungen der Formel I, worin $R_1$ unsubstituiertes $C_1$-$C_{12}$-Alkyl, Phenyl-$C_1$-$C_4$-Alkyl, unsubstituiertes oder durch $C_1$-$C_{12}$-Alkyl substituiertes Cyclopentyl oder Cyclohexyl bedeutet und $R_2$ und $R_3$ unabhängig voneinander für unsubstituiertes $C_1$-$C_{12}$-Alkyl, Phenyl-$C_1$-$C_4$-Alkyl unsubstituiertes oder durch $C_1$-$C_{12}$-Alkyl substituiertes Cyclopentyl oder Cyclohexyl oder unsubstituiertes oder durch $C_1$-$C_{12}$-Alkyl, $C_1$-$C_4$-Alkoxy oder Halogen substituiertes Phenyl stehen, vor allem solche, worin $R_1$ $C_1$-$C_{12}$-Alkyl, Cyclohexyl oder Phenyl-$C_1$-$C_4$-Alkyl bedeutet und $R_2$ und $R_3$ unabhängig voneinander für durch $C_1$-$C_4$-Alkoxy, Halogen oder $C_1$-$C_4$-Alkyl substituiertes Phenyl stehen.

In den Verbindungen der Formel I sind $R_2$ und $R_3$ vorzugsweise gleich.

Die Herstellung der Bisacylphosphine ist dem Fachmann aus der Literatur bekannt und z.B. in der EP-A-184 095 beschrieben.

So können sie z.B. durch Umsetzung eines entsprechenden Säurehalogenides oder einer Mischung von 2 Säurehalogeniden mit einem primären Phosphin vorzugsweise im ungefähren stöchiometrischen Verhältnis 2:1 in Gegenwart einer Base, insbesondere einer Aminbase, erhalten werden [(a), (b)]:

(a)

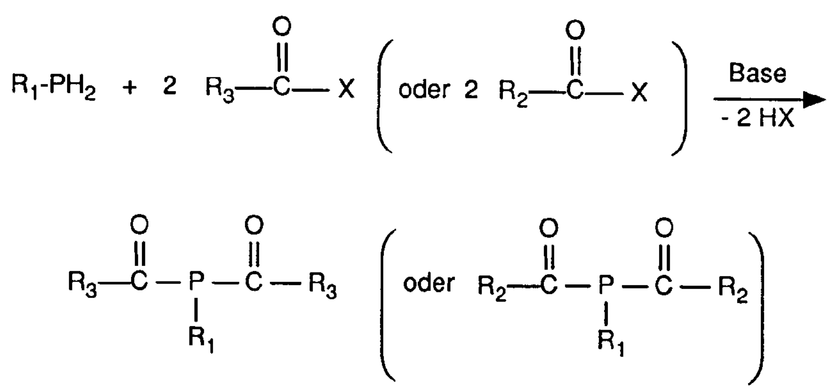


(b)

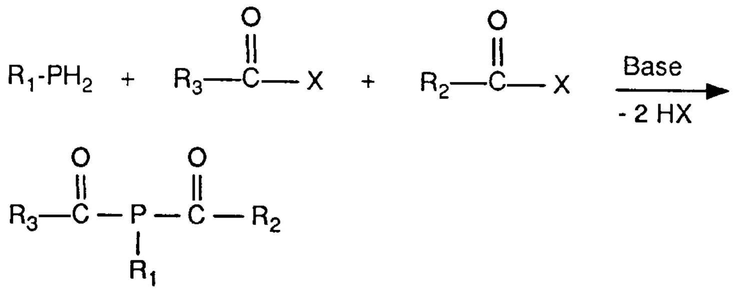


Das Phosphin kann dabei auch beispielsweise Bis(trimethylsilyl)-phosphin sein. Bei der Reaktion mit dem Säurehalogenid werden dann die Trimethylsilylgruppen durch den Saure-Rest ersetzt [(c)]:
(c)

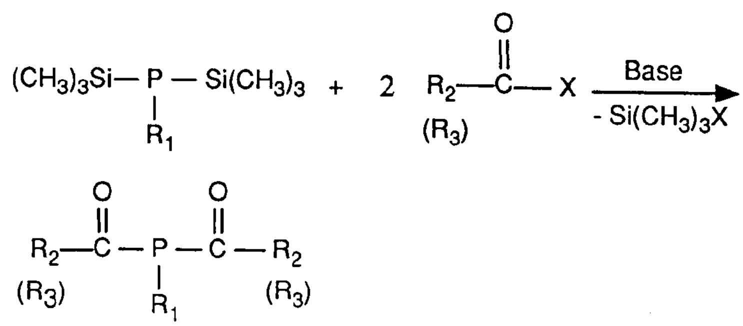


Die Reste $R_1$, $R_2$ und $R_3$ haben die im Patentanspruch angegebene Bedeutung, X steht für Halogen, vorzugsweise Chlor.

Die Herstellung der primären Phosphine ist dem Fachmann geläufig. Sie ist z.B. veröffentlicht in Houben-Weyl, Methoden der organischen Chemie, Bd. XII/1, Seiten 17-79, (1963), Georg Thieme Verlag Stuttgart, und Houben-Weyl, Methoden der organischen Chemie, Bd. E1 Seiten 106-183, (1982), Georg Thieme Verlag Stuttgart.

Ein weiterer Gegenstand der Erfindung ist die Verwendung von Verbindungen der Formel I als Photoinitiatoren für die Photopolymerisation ethylenisch ungesättigter Verbindungen.

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden. Als Komponente (a) in den erfindungsgemässen Zusammensetzungen kommen solche ethylenisch ungesättigte monomere, oligomere und polymere Verbindungen in Frage, die durch Photopolymerisation zu höhermolekularen Produkten reagieren und hierbei ihre Löslichkeit verändern.

Die ungesättigten Verbindungen können eine oder mehrere olefinische Doppelbindungen enthalten. Sie können niedermolekular (monomer) oder höhermolekular (oligomer) sein.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Polybutadien und Butadien. Copolymere, Polyisopren und Isopren-Copolymere, Polymere und Coplymere mit (Meth)Acrylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Triethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaeiythrit, Dipentaeerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind:

Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldiitaconat, Sorbittriacrylat, Sorbittetraacrylat, Pentaerythrit-modifizierttriacrylat, Sorbittetramethacrylat, Sorbitpentaacrylat, Sorbithexaacrylat, Oligoesteracrylate und -methacrylate, Glycerindi- und -triacrylat, 1,4-Cyclohexandiacrylat, Bisacrylate und Bismethacrylate von Polyethylenglykol mit Molekulargewicht von 200 bis 1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di-(β-aminopropoxy)ethan. Weitere geeignete Polyamine sind Polymere und Copolymere mit gegebenenfalls zusätzlichen Aminogruppen in der Seitenkette und Oligoamide mit Aminoendgruppen.
Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolakbasis mit (Meth)-Acrylsäure handeln, um Homo- oder Copolymere des Polyvinylalkohols oder deren Hydroxyalkylderivaten, die mit (Meth)-Acrylsäure verestert sind, oder um Homo- und Copolymere von (Meth)-Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittels kann z.B. 5-95, vorzugsweise 10-90 und besonders 50-90 Gew.-% betragen, bezogen auf die gesamte Zusammensetzung. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000-1 000 000. Beispiele sind: Homo- und Copolymere Acrylate und Methacrylate, z.B. Copolymere aus Methylmethacrylat/Ethylacrylat/Methacrylsäure, Poly(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polymere wie Polycaprolactam und Poly(hexamethylenadipamid), Polyester wie Poly(ethylenglykolterephtalat) und Poly(hexamethylenglykolsuccinat).

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die erfindungsgemässen photopolymerisierbaren Zusammensetzungen enthalten den Photoinitiator (b) zweckmässig in einer Menge von 0,05 bis 15 Gew.-%, vorzugsweise 0,2 bis 5 Gew.-%, bezogen auf die Zusammensetzung

Erfindungsgemäss sind auch Zusammensetzungen, die neben dem Photoinitiator (b) noch mindestens einen weiteren Photoinitiator und/oder andere Additive enthalten.

Enthalten die photopolymerisierbaren Gemische ausser dem Photoinitiator verschiedene andere Additive , so sind dies beispielsweise thermische Inhibitoren, die vor allem während der Herstellung der Zusammensetzungen durch Mischen der Komponenten, eine vorzeitige Polymerisation verhindern sollen, wie z.B. Hydrochinon, Hydrochinonderivate, p-Methoxyphenol, β-Naphthol oder sterisch gehinderte Phenole wie z.B. 2,6-Di(tert-butyl)p-kresol.

Zur Erhöhung der Dunkellagerstabilität können z.B. Kupferverbindungen, wie Kupfernaphthenat, -stearat, oder -octoat, Phosphorverbindungen, wie z.B. Triphenylphosphin, Tributylphosphin, Triethylphosphit, Triphenylphosphit oder Tribenzylphosphit, quarternäre Ammoniumverbindungen, wie z.B. Tetramethylammoniumchlorid oder Trimethyl-benzylammoniumchlorid, oder Hydroxylaminderivate, wie z.B. N-Diethylhydroxylamin, verwendet werden.

Zwecks Ausschluss des Luftsauerstoffes während der Polymerisation kann man Paraffin oder ähnliche wachsartige Stoffe zusetzen, die bei Beginn der Polymerisation wegen mangelnder Löslichkeit im Polymeren an die Oberfläche wandern und eine transparente Oberflächenschicht bilden, die den Zutritt von Luft verhindert.

Als Lichtschutzmittel können in geringer Menge UV-Absorber, wie z.B. solche vom Benztriazol-, Benzophenon- oder Oxalanilid-Typ, zugesetzt werden. Ebenso lassen sich Lichtschutzmittel vom Typus sterisch gehinderter Amine (HALS) zusetzen.

In bestimmten Fällen kann es von Vorteil sein, Gemische von zwei oder mehr der erfindungsgemässen Photoinitiatoren zu verwenden. Werden neben Photoinitiatoren der Formel I weitere Photoinitiatoren mitverwendet, kann es sich dabei z.B. um solche vom Typ der Benzophenone, der Acetophenonderivate, wie beispielsweise α-Hydroxyalkylphenylketone, Benzoinalkylether und Benzilketale, oder vom Typ der Acylphosphinoxide, Bisacylphosphinoxide oder Titanocene handeln.

Zur Beschleunigung der Photopolymerisation, vor allem in pigmentierten Zubereitungen, können Amine zugesetzt werden, wie z.B. Triethanolamin, N-Methyl-diethanolamin, p-Dimethylaminobenzoesäure-ethylester oder Michler's Keton. Die Wirkung der Amine kann verstärkt werden durch den Zusatz von aromatischen Ketonen vom Typ des Benzophenons.

Eine Beschleunigung der Photopolymerisation kann weiterhin durch Zusatz von Photosensibilisatoren geschehen, welche die spektrale Empfindlichkeit verschieben bzw. verbreitern. Dies sind insbesondere aromatische Carbonylverbindungen wie z.B. Benzophenon-, Thioxanthon-, Anthrachinon- und 3-Acylcumarinderivate sowie 3-(Aroylmethylen)-thiazoline.

Weitere übliche Zusätze sind - je nach Verwendungszweck - Füllstoffe, Pigmente, Farbstoffe, Haft-, Netz- oder Verlaufhilfsmittel.

Die photopolymerisierbaren Zusammensetzungen können für verschiedene Zwecke verwendet werden, beispielsweise als Druckfarbe, als Klarlack, als Weisslack, als Anstrichstoff, als Anstrichstoff für Aussenanstriche, für photographische Reproduktionsverfahren, für Bildaufzeichnungsverfahren oder zur Herstellung von Druckplatten, für die Stereolithographie, als Zahnfüllmassen, als Klebstoffe, als Ueberzüge von optischen Fasern, für gedruckte Schaltungen oder zur Beschichtung von elektronischen Teilen.

In Lacken verwendet man häufig Zweikomponeten-Gemische eines Prepolymeren mit einem mehrfach ungesättigten Monomeren oder Dreikomponenten-Gemische, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwenden muss.

Zwei- und Dreikomponentensysteme auf der Basis eines Prepolymeren werden sowohl für Druckfarben

als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide, Polychalkone oder Polyimide, wie sie in der DE-OS 2 308 830 beschrieben sind.

Die erfindungsgemässen photohärtbaren Zusammensetzungen eignen sich z.B. als Beschichtungsmittel für Substrate aller Art, z.B. Holz, Papier, Keramik, Kunststoffe wie Polyester und Celluloseacetatfilme und Metalle wie Kupfer und Aluminium, bei denen durch Photopolymerisation eine Schutzschicht oder eine Abbildung aufgebracht werden soll.
Die Beschichtung der Substrate kann erfolgen, indem man eine flüssige Zusammensetzung, eine Lösung oder Suspension auf das Substrat aufbringt. Das geschieht z.B. durch Tauchen, Aufpinseln, Spritzen oder Reverseroll-Beschichtung. Die Auftragsmenge (Schichtdicke) und Art des Substrates (Schichtträger) sind abhängig vom gewünschten Applikationsgebiet. Als Schichtträger für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 μm. Bei Mitverwenden von Lösungsmitteln werden diese nach dem Beschichten entfernt.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Druckfarben von Bedeutung.

Gut geeignet sind die erfindungsgemässen photohärtbaren Gemische auch zur Herstellung von Druckplatten. Hierbei werden z.B. Gemische von löslichen linearen Polyamiden oder Styrol/Butadien Kautschuk mit photopolymerisierbaren Monomeren, beispielsweise Acrylamiden, und einem Photoinitiator verwendet. Filme und Platten aus diesen Systemen (nass oder trocken) werden über das Negativ (oder Positiv) der Druckvorlage belichtet und die ungehärteten Anteile anschliessend mit einem Lösungsmittel eluiert.

Ein weiteres Einsatzgebiet der Photohärtung ist die Metallbeschichtung, beispielsweise bei der Lackierung von Blechen und Tuben, Dosen oder Flaschenverschlüssen, sowie die Photohärtung von Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung von photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösungsmittel (=Entwickler) entfernt. Das Aufbringen der photohärtbaren Schicht kann auch im Elektroabscheidungsverfahren auf Metall geschehen. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Gegenstand der Erfindung ist auch ein Verfahren zur Photopolymerisation von monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I zugibt und mit Licht im Bereich von 200 bis 600 nm bestrahlt.

Die Polymerisation erfolgt nach den bekannten Methoden der Photopolymerisation durch Bestrahlung mit Sonnenlicht oder mit Licht, das reich an kurzwelliger Strahlung ist. Als Lichtquellen sind z.B. Quecksilbermitteldruck-, -hochdruck- und -niederdruckstrahler, superaktinische Leuchtstoffröhren, Metallhalogenid-Lampen oder Laser geeignet, deren Emissionsmaxima im Bereich zwischen 250 und 450 nm liegen. Laserlichtquellen haben den Vorteil, dass keine Photomasken notwendig sind, da der gesteuerte Laserstrahl direkt auf die photohärtbare Schicht schreibt. Im Falle einer Kombination mit Photosensibilisatoren können auch längerwelliges Licht oder Laserstrahlen bis 600 nm verwendet werden.

Die Zusammensetzungen werden zweckmässig durch Mischen der einzelnen Komponenten hergestellt.

Ein weiterer Gegenstand der Erfindung ist eine gehärtete Zusammensetzung, die nach dem oben beschriebenen Verfahren erhalten wird.

Die Bisacylphosphin-Photoinitiatoren der Formel I zeichnen sich durch eine gute Löslichkeit in den Substraten aus. Es sind Photoinitiatoren mit guter Reaktivität. Substrate, welche die erfindungsgemässen Bisacylphosphin-Photoinitiatoren enthalten, zeigen eine nur geringe Vergilbung, und zudem erleiden sie nur eine

geringe Inhibierung der Polymerisation durch Luftsauerstoff.

Die nachfolgenden Beispiele erläutern die Erfindung weiter. Angaben in Teilen oder Prozenten beziehen sich, ebenso wie in der übrigen Beschreibung und den Patentansprüchen, auf das Gewicht, sofern nichts anderes angegeben ist.

Beispiel 1: Herstellung von Bis(2,6-dimethoxybenzoyl)-(2-methylpropyl)-phosphin

Zu 18,8 g (0,0935 mol) 2,6-Dimethoxybenzoylchlorid in 100 ml Toluol wird bei 100- 110 °C innerhalb von 30 Minuten ein Gemisch aus 5 ml (0,0425 mol) (2-Methylpropyl)-phosphin und 13 ml (0,0935 mol) Triethylamin getropft. Zur Vervollständigung der Umsetzung wird bei gleicher Temperatur das Reaktionsgemisch noch 6 Stunden lang gerührt. Das Produkt, sowie Triethylammoniumchlorid fallen dabei als gelblicher Niederschlag aus. Nach dem Abkühlen der Reakrionsmischung wird das Ammoniumsalz durch Zugabe von Wasser gelöst und das Produkt durch Filtration isoliert. Nach der Trocknung im Vakuum erhält man 11,1 g (62,5 % d. Th.) der Titelverbindung als weisses Pulver mit einem Schmelzpunkt von 138-140 °C.

| | | | | | | |
|---|---|---|---|---|---|---|
| Elementaranalyse: | C | ber.: | 63,15 % | H | ber.: | 6,50 % |
| | | gef.: | 63,19 % | | gef.: | 6,52 % |

Beispiel 2: Herstellung von Bis(2,6-dichlorbenzoyl)-benzylphosphin

Zu 38,0 ml (0,266 mol) 2,6-Dichlorbenzoylchlorid in 200 ml Toluol wird bei 100-110 °C innerhalb von 30 Minuten ein Gemisch aus 39,5 g (0,12 mol) Benzylphosphin (als 38%ige Lösung in Toluol) und 37,1 ml (0,266 mol) Triethylamin getropft. Zur Vervollständigung der Umsetzung wird bei gleicher Temperatur das Reaktionsgemisch noch 6 Stunden lang gerührt. Das Reaktionsgemisch wird dann mit Toluol verdünnt und zweimal mit Wasser und verdünnter Bicarbonatlösung gewaschen. Nach dem Trocknen der organischen Phase über Magnesiumsulfat wird sie im Vakuum eingeengt. Das ausgefallene Reaktionsprodukt wird aus Essigester umkristallisiert. Man erhält 26,8 g (45,5 % d. Th.) der Titelverbindung als weisses Pulver mit einem Schmelzpunkt von 136-137 °C.

Elementaranalyse:

| | | | | | | | | |
|---|---|---|---|---|---|---|---|---|
| C | ber.: | 53,65 % | H | ber.: | 2,79 % | Cl | ber.: | 30,17 % |
| | gef.: | 53,66 % | | gef.: | 2,85 % | | gef.: | 30,50 % |

Beispiele 3 - 5:

Die Verbindungen der Beispiele 3, 4 und 5 werden unter Verwendung der entsprechenden primären Phosphine als Ausgangsprodukte analog zu der in Beispiel 1 angegebenen Vorschrift hergestellt.
Die Verbindungen und ihre physikalische Daten sind der nachfolgenden Tabelle 1 zu entnehmen.

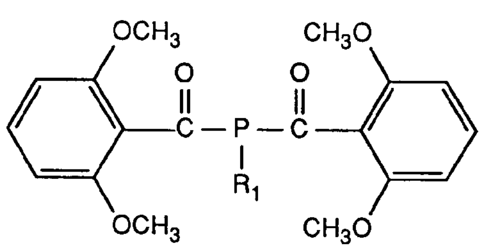

Tabelle 1

| Beispiel Nr. | $R_1$ | Schmelzpunkt [°C] | Elementaranalyse [%] C | H | ber. gef. |
|---|---|---|---|---|---|
| 3 | 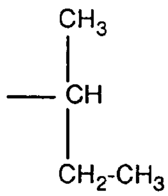 | 121-123 | 63,15<br>63,09 | 6,50<br>6,37 | |
| 4 | Benzyl | 155-157 | 66,37<br>66,20 | 5,57<br>5,65 | |
| 5 | n-Butyl | 113-116 | 63,15<br>62,87 | 6,50<br>6,80 | |

Beispiel 6: Herstellung von Bis(2,6-dimethoxybenzoyl)-2,4,4-trimethylpentyl-phosphin

Die Verbindung wird unter Verwendung des entsprechenden primären Phosphins als Ausgangsprodukt analog zu der in Beispiel 2 angegebenen Vorschrift hergestellt. Die Titelverbindung hat einen Schmelzpunkt von 114- 117 °C.
Elementaranalyse:

| | | | | | |
|---|---|---|---|---|---|
| C: | ber.: | 65,81 % | H | ber.: | 7,43 % |
| | gef.: | 65,70 % | | gef.: | 7,59 % |

Beispiel 7: Herstellung von Bis(2,4,6-trimethylbenzoyl)-benzylphosphin

Innerhalb von 30 Minuten werden unter Stickstoff bei 0-5 °C zu einer Lösung aus 14,2 ml (0,10 mol) Diisopropylamin in 25 ml Tetrahydrofuran 62,5 ml (0,10 mol/1,6 M) Butyllithium getropft. Diese Lösung wird bei -30 bis -40 °C innerhalb von 90 Minuten zu einer Lösung aus 18,3 g (0,10 mol) 2,4,6-Trimethylbenzoylchlorid und 14,9 g (0,046 mol; 38 % in Toluol) Benzylphosphin in 60 ml Tetrahydrofuran getropft. Nach 2 Stunden Rühren bei -30 °C wird die gelbe Lösung auf Raumtemperatur erwärmen lassen und einmal mit Wasser gewaschen. Die organische Phase wird danach mit Magnesiumsulfat getrocknet, filtriert und am Rotationsverdampfer eingeengt. Nach Chromatographie (Laufmittel: Hexan/Essigester 9:1) und anschliessender Umkristallisation des Rückstandes aus Hexan wird die Titelverbindung als gelbes Pulver mit einem Schmelzpunkt von 129- 130 °C erhalten.
Elementaranalyse:

| | | | | | |
|---|---|---|---|---|---|
| C | ber.: | 77,86 % | H | ber.: | 7,02 % |
| | gef.: | 78,28 % | | gef.: | 7,18 % |

Beispiel 8: Initiator-Reaktivität in einem Weisslack

Es wird eine photopolymerisierbare Zusammensetzung bereitet aus:

30 % ®Ebecryl 608 (Epoxy-acrylat der Fa. UCB, Belgien)
15 % Trimethylolpropan-trisacrylat (Degussa)
5 % N-Vinylpyrrolidon (Fluka)
50 % Titandioxid (Rutil-Typ; ®R-TC2 der Fa. Tioxide, Frankreich)

Zu dieser Zusammensetzung werden 2 Gew.-% des zu prüfenden Photoinitiators aus Beispiel 1 gemischt. Die Formulierung wird in einer Schichtdicke von 100 μm auf Aluminiumbleche und in einer Schichtdicke 30 μm auf Glas aufgetragen. Die 30 μm-Schichten werden dann durch Bestrahlung mit Quecksilbermitteldrucklampen (2 X 80 W/cm; Lampentyp: PPG) und einer 120 W/cm Fusion D Lampe gehärtet. Dabei wird die Probe so oft auf einem Band, welches mit einer Geschwindigkeit von 10 m/min läuft, unter den Lampen hergeführt, bis eine wischfeste Lackoberfläche erreicht ist. Je geringer die Anzahl der Durchläufe, desto höher ist die Reaktivität der getesteten Verbindung. Für beide Lampentypen wird die maximale Bandgeschwindugkeit zur Erreichung der Wischfestigkeit in m/min besimmt. (Angabe der Durchläufe [n] bei Bandgeschwindigkeit y [m/min]). Die 100 μm-Schichten werden durch Bestrahlung mit einer Quecksilbermitteldrucklampe (80 W/cm; Lampentyp: Hanovia) gehärtet. Es wird die maximale Bandgeschwindigkeit zur Erreichung der Durchhärtung in m/min bestimmt (Angabe der Durchläufe [n] bei Bandgeschwindigkeit y [m/min]). Die Härte der Probe wird durch Messung der Pendelhärte nach König (DM 53157) bestimmt. Je höher die Zahl der Sekunden, desto härter ist die getestete Probe. Die Vergilbung der Probe wird als Yellowness-Index (YI) nach ASTM D 1925-70 gemessen. Je kleiner der Wert, desto geringer ist die Vergilbung der Probe. Die Pendelhärte und die Vergilbung werden sofort nach der Härtung und nach einer zusätzlichen Belichtung von 15 Minuten und 16 Stunden unter 4 Lampen des Typs TL 40/03 (Leistung: 40 W; Philips) gemessen. Die Glanzmessung erfolgt nach ASTM D 523 in einem Einfallswinkel von 20 und 60 ° nach einer zusätzlichen Belichtung von 15 Minuten und 16 Stunden. Angegeben wird der Anteil des reflektierten Lichts in %. Je höher die Werte, desto besser ist der Glanz. Die Ergebnisse für die 100 μm-Schicht sind in Tabelle 2 zusammengefasst, die Ergebnisse der 30 μm-Schicht sind der Tabelle 3 zu entnehmen.

Tabelle 2: 100 μm-Schicht

| Verbindung aus Beispiel Nr. | Durchhärtung n x y [m/min] | Pendelhärte [s] sofort | 15 min | 16 h | YI sofort | 15 min | 16 h | Glanz 20/60° [in %] 15 min | 16 h |
|---|---|---|---|---|---|---|---|---|---|
| 1 | 2 x 10 | 50 | 98 | 193 | 0,8 | 1,2 | 1,8 | 85/92 | 83/91 |

Tabelle 3: 30 μm-Schicht

| Verbindung aus Beispiel Nr. | Wischfestigkeit n x y [m/min] 160 W/cm | 120 W/cm |
|---|---|---|
| 1 | 2 x 10 | 2 x 10 |

Beispiel 9: Initiator-Reaktivität in einem Weisslack

Der Photoinitiator aus Beispiel 3 wird zu 2 Gew.-% in einer Formulierung aus

67,5 % ®Ebecryl 830 (Polyesteracrylat; UCB, Belgien)
5,0 % 1,6-Hexandioldiacrylat
2,5 % Trimethylolpropan-trisacrylat
25,0 % Titandioxid (Rutil-Typ; Tioxide, Frankreich)

eingearbeitet. Die erhaltene Mischung wird mit einer 100 μm Spaltrakel auf ein Aluminiumblech aufgetragen. Die Härtung der aufgetragenen Schicht erfolgt durch Belichtung mit einer 80 W/cm Quecksilbermitteldrucklampe (Typ Hanovia), wobei die Probe auf einem Band, welches mit einer Geschwindigkeit von 10 m/min bewegt wird, unter der Lampe durchgeführt wird. Es wird die zur Wischfestigkeit der Schicht erforderliche Anzahl der Durchläufe der Probe gemessen. Sofort nach der Härtung werden der Yellowness-Index (ASTM D 1925-70) und die Pendelhärte nach König (Din 53157) bestimmt. Es erfolgt eine Nachbelichtung unter vier Lampen des Typs TL 40/03 (Philips) für 15 min, bzw. 16 h. Nach diesen Zeitintervallen werden wider jeweils der Yellowness-Index und die Pendelhärte bestimmt. Je kleiner der Wert des Yellowness-Index ist, desto geringer ist die Vergilbung der Probe. Je höher die Zahl der Sekunden bei der Messung der Pendelhärte, desto härter ist die getestete Probe. Das Ergebnis ist in der Tabelle 4 wiedergegeben.

Tabelle 4: 100 µm-Schicht

| Verbindung aus Beispiel Nr. | Anzahl Durchläufe bei 10 m/min | Pendelhärte [s] | | | YI | | |
|---|---|---|---|---|---|---|---|
| | | sofort | 15 min | 16 h | sofort | 15 min | 16 h |
| 3 | 4 | 147 | 165 | 189 | 2,4 | 1,7 | 0 |

<u>Beispiel 10:</u> Initiator-Reaktivität in einem Klarlack

2 Gew.-% des Photoinitiators aus Beispiel 1 werden in eine Formulierung aus

99,5 % ®Roskydal UV 502 A (Lösung eines ungesättigten Polyesters in Styrol; Fa. Bayer, BRD) und

0,5 % ®Byk 300 (Verlaufhilfsmittel; Fa. Byk-Mallinckrodt)

eingearbeitet. Die erhaltene Mischung wird in einer Schichtdicke von 100 µm auf Spanplatten, die mit weissem Kunstharz beschichtet sind, aufgetragen. Die Härtung der aufgetragenen Schicht erfolgt durch Belichtung in einem PPG Bestrahlungsgerät mit Quecksilbermitteldrucklampen (2 x 80 W/cm), wobei die Probe auf einem Band, welches mit einer Geschwindigkeit von 20 m/min bewegt wird, unter der Bestrahlungsquelle durchgeführt wird. Ermittelt werden erstens die Anzahl der Durchläufe, die nötig ist um die Schicht bis zur Wischfestigkeit zu härten und zweitens der Yellowness Index (ASTM D 1925-70) nach der Härtung. Je geringer die Anzahl der Durchläufe, desto reaktiver ist der getestete Photoinitiator. Je kleiner der Wert des Yellowness Index, desto geringer ist die Vergilbung der Probe. Das Ergebnis ist in der Tabelle 5 wiedergegeben.

Tabelle 5: 100 µm-Schicht

| Verbindung aus Beispiel Nr. | Durchhärtung n x y [m/min] | Yellowness Index |
|---|---|---|
| 1 | 4 x 20 | 7,4 |

## Patentansprüche

1. Photopolymerisierbare Zusammensetzung enthaltend
   (a) mindestens eine ethylenisch ungesättigte photopolymerisierbare Verbindung und
   (b) als Photoinitiator mindestens eine Verbindung der Formel I

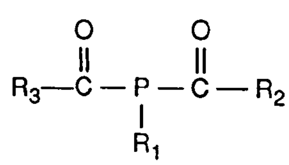

(I),

worin $R_1$ unsubstituiertes $C_1$-$C_{18}$-Alkyl oder durch Phenyl, -CN, $C_1$-$C_{12}$-Alkoxy oder Halogen substituiertes $C_1$-$C_8$-Alkyl, $C_2$-$C_{18}$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest bedeutet und
$R_2$ und $R_3$ unabhängig voneinander für unsubstituiertes $C_1$-$C_{18}$-Alkyl oder durch Phenyl, Halogen oder $C_1$-$C_{12}$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_{12}$-Alkoxy oder Halogen substituiertes $C_5$-$C_8$-Cycloalkyl, unsubstituiertes oder durch $C_1$-$C_{12}$-Alkyl, $C_1$-$C_{12}$-Alkoxy, $C_2$-$C_{12}$-Alkoxyalkyl,
$C_1$-$C_4$-Alkylthio oder Halogen substituiertes $C_6$-$C_{12}$-Aryl oder einen unsubstituierten oder durch Halogen, $C_1$-$C_4$-Alkyl oder $C_1$-$C_4$-Alkoxy substituierten 5- oder 6-gliedrigen O-, S-oder/und N-haltigen aromatischen

heterocyclischen Rest stehen.

2. Zusammensetzung nach Anspruch 1, worin $R_1$ unsubstituiertes $C_1$-$C_{12}$-Alkyl oder durch Phenyl, -CN, $C_1$-$C_4$-Alkoxy oder Halogen substituiertes $C_1$-$C_8$-Alkyl, $C_2$-$C_{12}$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder einen unsubstituierten oder durch Halogen, $C_1$-$C_4$-Alkyl oder $C_1$-$C_4$-Alkoxy substituierten O-, S- oder/und N-haltigen 5- oder 6-gliedrigen aromatischen heterocyclischen Rest bedeutet und
$R_2$ und $R_3$ unabhängig voneinander für unsubstituiertes $C_1$-$C_{12}$-Alkyl oder durch Phenyl, Halogen oder $C_1$-$C_4$-Alkoxy substituiertes $C_1$-$C_8$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl, unsubstituiertes oder durch $C_1$-$C_{12}$-Alkyl, $C_1$-$C_4$-Alkoxy, $C_2$-$C_8$-Alkoxyalkyl,
$C_1$-$C_4$-Alkylthio oder Halogen substituiertes $C_6$-$C_{12}$-Aryl oder einen unsubstituierten oder durch Palogen, $C_1$-$C_4$-Alkyl oder $C_1$-$C_4$-Alkoxy substituierten 5- oder/und 6-gliedrigen O-, S- oder N-haltigen aromatischen heterocyclischen Rest stehen.

3. Zusammensetzung nach Anspruch 2, worin $R_1$ unsubstituiertes $C_1$-$C_{12}$-Alkyl oder durch Phenyl, -CN, $C_1$-$C_4$-Alkoxy oder Halogen substituiertes $C_1$-$C_4$-Alkyl, $C_2$-$C_6$-Alkenyl oder unsubstituiertes oder durch $C_1$-$C_{12}$-Alkyl, $C_1$-$C_4$-Alkoxy oder Halogen subsbtuiertes $C_5$-$C_8$-Cycloalkyl bedeutet und
$R_2$ und $R_3$ unabhängig voneinander für unsubstituiertes $C_1$-$C_{12}$-Alkyl oder durch Phenyl, Halogen oder $C_1$-$C_4$-Alkoxy substituiertes $C_1$-$C_4$-Alkyl, $C_2$-$C_6$-Alkenyl, unsubstituiertes oder durch $C_1$-$C_{12}$-Alkyl, $C_1$-$C_4$-Alkoxy oder Halogen substituiertes $C_5$-$C_8$-Cycloalkyl oder unsubstituiertes oder durch $C_1$-$C_{12}$-Alkyl, $C_1$-$C_4$-Alkoxy, $C_2$-$C_8$-Alkoxyalkyl, $C_1$-$C_4$-Alkylthio oder Halogen substituiertes $C_6$-$C_{12}$-Aryl stehen.

4. Zusammensetzung nach Anspruch 3, worin $R_1$ unsubstituiertes $C_1$-$C_{12}$-Alkyl, Phenyl-$C_1$-$C_4$-Alkyl, unsubstituiertes oder durch $C_1$-$C_{12}$-Alkyl substituiertes Cyclopentyl oder Cyclohexyl bedeutet und
$R_2$ und $R_3$ unabhängig voneinander für unsubstituiertes $C_1$-$C_{12}$-Alkyl,
Phenyl-$C_1$-$C_4$-Alkyl, unsubstituiertes oder durch $C_1$-$C_{12}$-Alkyl substituiertes Cyclopentyl oder Cyclohexyl oder unsubstituiertes oder durch $C_1$-$C_{12}$-Alkyl, $C_1$-$C_4$-Alkoxy oder Halogen substituiertes Phenyl stehen.

5. Zusammensetzung nach Anspruch 4, worin $R_1$ $C_1$-$C_{12}$-Alkyl, Cyclohexyl oder Phenyl-$C_1$-$C_4$-Alkyl bedeutet und $R_2$ und $R_3$ unabhängig voneinander für durch $C_1$-$C_4$-Alkoxy, Halogen oder $C_1$-$C_4$-Alkyl substituiertes Phenyl stehen.

6. Zusammensetzung nach einem der Ansprüche 1 bis 5, worin $R_2$ und $R_3$ gleich sind.

7. Zusammensetzung nach Anspruch 1, dadurch gekennzeichnet, dass sie neben dem Photoinitiator (b) noch mindestens einen weiteren Photoinitiator und/oder andere Additive enthält.

8. Zusammensetzung nach Anspruch 1, enthaltend 0,05 bis 15, insbesondere 0,2 bis 5 Gew.- % der Komponente (b), bezogen auf die Zusammensetzung.

9. Verfahren zur Photopolymerisation von Verbindungen mit ethylenisch ungesättigten Doppelbindungen, dadurch gekennzeichnet, dass man eine Zusammensetzung nach Anspruch 1 mit Licht im Bereich von 200 bis 600 nm bestrahlt.

10. Verwendung von Verbindungen der in Anspruch 1 definierten Formel I als Photoinitiatoren für die Photopolymerisation ethylenisch ungesättigter Verbindungen.

11. Gehärtete Zusammensetzung, erhalten nach dem Verfahren gemäss Anspruch 9.

Europäisches Patentamt

# EUROPÄISCHER RECHERCHENBERICHT

Nummer der Anmeldung

EP 92 81 0005

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X,D | US-A-3 668 093 (T. A. RETTIG)<br>* das ganze Dokument *<br>--- | 1-11 | C08F2/50<br>G03F7/029 |
| A | EP-A-0 106 176 (BASF)<br>--- | 1-11 | |
| A | EP-A-0 062 839 (BASF)<br>----- | 1-11 | |

| RECHERCHIERTE SACHGEBIETE (Int. Cl.5 ) |
|---|
| C08F<br>G03F |

Der vorliegende Recherchenbericht wurde für alle Patentansprüche erstellt

| Recherchenort | Abschlußdatum der Recherche | Prüfer |
|---|---|---|
| DEN HAAG | 26 MAERZ 1992 | ANDRIOLLO G.R. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)